# EUROPEAN PATENT APPLICATION

(11) **EP 1 511 072 A2**
(43) Date of publication of application: **02.03.2005**
(21) Application number: 04104013.0
(22) Date of filing: 20.08.2004
(51) Int. Cl.: H01L 21/3105, H01L 21/768

(54) **Post-etch clean process for porous low dielectric constant materials**

(30) Priority: 26.08.2003 US 647985 P
(71) Applicant: TEXAS INSTRUMENTS INCORPORATED, Dallas, TX 75265 (US)
(72) Inventor: Beauregard Smith, Patricia, 76034, Colleyville (US); Park, Heungsoo, 75070, McKinney (US); Zielinski, Eden, 75082, Richardson (US)
(74) Representative: Holt, Michael

(57) **Abstract**

Standard post-etch photoresist clean procedures for porous dielectric materials in semiconductor device manufacturing may involve wet cleans in which a solvent is used for polymer residue removal. In many cases, the components of the solvent are absorbed into porous film layers (102) and can later volatilize during subsequent metal (110) deposition steps. A low pressure anneal of limited duration and high temperature, performed after the wet clean and prior to metal deposition, satisfactorily removes the absorbed components.

## Description

### FIELD OF THE INVENTION

The present disclosure is generally related to the field of semiconductor manufacturing, and more specifically to a method of removing volatile compounds from exposed dielectric material prior to metal deposition.

### BACKGROUND OF THE INVENTION

Semiconductor devices, such as microchip circuits, are typically formed through cycles of deposition, patterning and etching a semiconductor substrate or wafer. Photolithography is one available process by which a circuit pattern or other structure is formed on a wafer. Photoresist is a light-sensitive organic polymer that is used to develop a pattern which masks or protects some areas of the wafer during an etch process.

Wafer cleaning, particularly the removal of photoresist and post-etch polymers, has always been of paramount importance in achieving high quality devices in semiconductor manufacturing. Improper cleaning can lead to lower yields, manufacturing tool failure and reduced semiconductor device performance. Standard cleans are performed with known dry and/or wet clean processes. For example, standard post-etch clean procedures use a dry (plasma) clean to strip the photoresist followed by a wet (solvent or acid-based) clean to remove post-strip polymer residues. After one or more cleans are performed, the wafer then undergoes one or more metal deposition steps.

It has been found that certain components of wet clean solvents may inadvertently be absorbed into porous materials used in device processing during the wet clean process, particularly materials such as organosilicate glass (OSG), carbon-doped silicon-oxides (SiOC or CDO), or methylsilsesquioxane (MSQ). In many cases, these solvent components can volatilize during the subsequent metal deposition steps. Such components are not readily detectable following the wet clean through standard surface inspection by scanning electron microscope (SEM). However, these volatile components have been found to be present through the use of residual gas analyzers (RGA) during the metal barrier depositions and when not addressed, have resulted in the rejection and loss of entire production lots of post-etch wafers.

With the continued scaling of devices below 100 nanometers (nm) and the introduction of new semiconductor materials, standard wafer cleaning processes need to be refined in order to alleviate and prevent future failures or re-works and increase semiconductor device production yields. Accordingly, there is a need for an enhanced post-etch clean process that addresses certain problems of existing technologies.

### SUMMARY OF THE INVENTION

It is an object of the present disclosure, therefore, to present particular processes for cleaning an etched semiconductor wafer. Prior to a metal deposition step, the post-etch wafer may be subjected to one or more clean processes. For example, a plasma clean may be performed to remove a photoresist from the wafer. Remaining polymeric residue may then be removed using a wet clean process in which a standard solvent is applied.

Application of the solvent may cause one or more volatile solvent components or byproducts to be inadvertently absorbed into the wafer structure. In order to effectively remove such components, a high-temperature, low-pressure anneal of short duration is introduced after a wet clean process and prior to a metal deposition process, whereby the volatile compounds are substantially eradicated without affecting the critical dimension of the semiconductor structure or causing metal extrusion into etched features from underlying metal layers.

### BRIEF DESCRIPTION OF THE DRAWINGS

Further aspects of the present disclosure will be more readily appreciated upon review of the detailed description of its various embodiments, described below, when taken in conjunction with the accompanying drawings, of which:

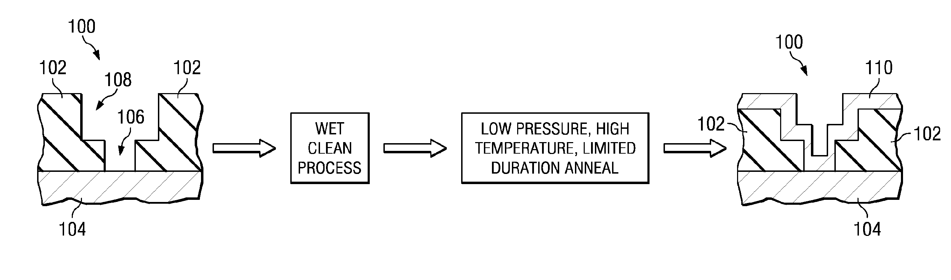

FIG. 1 is a flow diagram of a post-etch wafer before and after a metal deposition.

### DETAILED DESCRIPTION OF THE SPECIFIC EMBODIMENTS

Referring now to FIG. 1, various features of a post-etch clean process for porous dielectric materials will now be described.

An etched wafer 100 includes a semiconductor substrate (not pictured) which forms the base layer upon which all active device structures and interconnection structures are built and which includes dielectric layer 102 and one or more underlying metal layers 104. In particular embodiments, the layer 102 may be made of a low-dielectric constant (k) material, such as OSG (k ∼ 2.7), and the underlying metal layers 104 are made of copper (Cu). However, it should be readily appreciated that the dielectric material 102 may be any useful or known organic or inorganic materials with varying k, such as fluorine-doped silicate glass (FSG), silicon-dioxide (SiO₂), or MSQ and known variants of these materials, including more porous versions of these materials. Available low-k (having k <=3.0) alternatives to OSG include, but are not limited to, MSQ-based, low-k porous dielectrics of the type developed by JSR CORPORATION (k ∼ 2.2), APPLIED MATERIALS "BLACK DIAMOND" materials, or NOVELLUS CORPORATION CORAL OSG. It should also be readily understood that the underlying metal layers 104, as well as the metal used in subsequent metallization steps, may be any useful metal, such as aluminum (Al) and/ or copper.

The etched wafer 100 includes a via 106 and/or a trench 108 resulting from prior patterning and etch steps (not shown). The via 106 and trench 108 may result from any of a variety of known processing steps, including photolithography, in which a photoresist is applied to designate a pattern in a wafer that is subsequently etched. The formation of the interconnect wiring of an integrated circuit device may occur in accordance with various single damascene processes, in which vias and trenches are formed simultaneously, or dual damascene processes, in which the vias and the trenches are formed in separate etching steps. According to dual damascene practices, vias may be formed before trenches or vice-versa. Any of a variety of additional steps are performed to produce active device components as well as the interconnect wiring of the chip, during which time the etched wafer 100 is produced. Etch steps may include an etch-stop etch, a shallow trench isolation (STI)-etch, a gate-etch, a metal-etch and a contactetch. One of skill in the art will readily appreciate that the etched wafer 100 is not limited to the exemplary structure depicted in FIG. 1 and, in fact, may be in any of a variety of forms useful for producing semiconductor devices.

After the etch steps are performed, the etched wafer 100 is subject to one or more clean processes to remove all undesirable materials from the surface of the wafer without causing damage to the wafer layers. Various wet clean and/or dry clean technologies may be used, and either may be repeated a number of times as needed. In particular embodiments, the etched wafer 100 may first be subjected to a dry clean process (not shown) to remove the photoresist after etching. The dry clean may include an application of a hydrogen (H) plasma and may further include H, oxygen (O), and/or an inert gas, such as argon (Ar), helium (He), neon (Ne), xenon (Xe) or some other inert gas, the plasma generated by applying radio frequency (RF) or microwave frequency radiation. In certain embodiments, a plasma strip (also referred to as photoresist removal or ashing) may be applied in a heated environment. The dry clean is performed for a limited duration, typically within the range of approximately 30 seconds to several minutes, depending on the resist thickness and the process used to remove it. The process must be of sufficient duration to effectively remove the photoresist without affecting a critical dimension (CD) of the semiconductor structure or causing metal extrusion of the underlying metal layers 104, which may happen particularly in devices with larger metal widths.

The dry clean typically leaves some polymeric residues on the surface of the layer 102. Accordingly, a wet clean process may next be performed, in which a solvent is applied to the surface of the layer 102 in order to remove the remaining residues. The solvent may be any standard wet clean solvent, including fluorine-based solvents or acids, and may include dimethyl acetamide (DMAC), such as those solvents commercially available from ASHLAND CORPORATION and other suppliers of semiconductor cleaning fluids. Particular wet clean processes, such as those involving wet benches, spin/rinse/dryers, and brush scrubbers may also be included.

In prior known semiconductor device manufacturing processes, the wet clean (or the last of a series of wet cleans) was the step immediately prior to a metal deposition step (such as a barrier deposition or a metal seed layer deposition) in which a metal 110 is deposited on the surface of the exposed dielectric layer 102. However, production lots which were analyzed by RGA during the barrier deposition process have occasionally failed due to high levels of organic material observed in the RGA trace coming from the wafer prior to the metal deposition step, and would accordingly have to be re-worked. It was initially assumed that the resist removal had not been complete. However, polymer residues were not detected in the failed lots by SEM inspection. The failed lots were sent back for a second H-plasma strip performed at 250°C for 45 seconds with a commercial asher. The re-worked lots were then tested to determine whether the lots were acceptable. Such re-worked lots passed RGA analysis. However, the use of RF power to generate the plasma for that short duration of 45 seconds resulted in undesirable OSG dielectric film loss and unwanted increases in CDs.

It was later determined that the wet clean solvent left a mass-to-charge (m/e) 59 component that was absorbed in the dielectric film layer 102. Such solvent components would volatilize during the barrier deposition step, resulting in later tool and device failures.

It was found that the volatile components were successfully removed, without affecting CD or causing metal extrusions, by performing an anneal of elevated temperature in a low pressure (from substantially one atmosphere of pressure to a substantial vacuum) environment for a limited duration of time. In practice, most such anneals may be limited in duration to at most three minutes, or may extend up to approximately six minutes dependent on the type of low-k material used. Longer durations could be employed if they do not adversely affect device performance, but such durations are still generally limited to the scale of a few minutes.

The temperature must be above the boiling points of the major components of the solvent to remove the absorbed volatile components. However, the temperature must not be sufficiently high so as to effect device performance, such as by allowing passive extrusions.

It was found that, in the case of copper in the underlying metal layer 104 of an OSG etched wafer 100, the temperature should not exceed approximately 300° Celsius, in order to avoid such extrusions. In a particular embodiment, an anneal at 250° Celsius for a duration of 45 seconds was found to completely remove the absorbed components from OSG wafers, without the OSG film loss or copper extrusions resulting from the limited duration plasma re-work described previously.

The anneal may be performed in a furnace of suitable design to achieve the anneal parameters specified. The anneal may also be performed in an asher operated without applying RF or microwave radiation, but with the wafer held in the processing chamber at elevated temperature, and in less than one atmosphere pressure.

Although the best methodologies of the invention have been particularly described in the foregoing disclosure, it is to be understood that such descriptions have been provided for purposes of illustration only, and that other variations both in form and in detail can be made thereupon by those skilled in the art without departing from the spirit and scope of the present invention, which is defined first and foremost by the appended claims.

## Claims

1. A method for cleaning a wafer in between steps of a semiconductor manufacturing process, comprising:
cleaning a low-k dielectric material surface on the wafer using a wet clean solvent following an earlier process step; and
performing an anneal of the surface to remove a component of the solvent prior to a later process step.

2. The method of claim 1, wherein the earlier process step comprises an etching step and the later process step comprises a metal deposition step.

3. The method of either claim 1 or claim 2, wherein the dielectric material comprises at least one of : an organosilicate glass (OSG), a methylsilsesquioxane (MSQ) dielectric material, a fluorine-doped silicate glass (FSG), and a silicon-dioxide (SiO₂).

4. The method of any of claims 1 - 3, wherein the wet clean solvent comprises an acid.

5. The method of any of claims 1 - 4, wherein the component comprises dimethyl acetamide (DMAC).

6. The method of any of claims 1 -5, further comprising performing a dry clean of the wafer to remove a photoresist, prior to performing the anneal.

7. The method of claim 6, the dry clean step comprising applying a plasma including at least one of: hydrogen, oxygen and an inert gas.

8. The method of any of claims 1 - 7, the anneal comprising a low-pressure anneal performed in substantially a vacuum at a temperature that is higher than a boiling point of the component and for a duration that does not alter a critical dimension of the wafer nor cause a metal extrusion.

9. The method of any of claims 1 - 8, wherein the anneal is performed at a temperature of less than or equal to 300 degrees Celsius.

10. The method of any of claims 1 - 9, wherein the anneal is performed for a duration of at most three minutes.

11. The method of any of claims 1 - 10, wherein the earlier process step comprises an etch process including at least one of: a via-etch process, a trench-etch process, or an etch-stop etch process

12. The method of any of claims 1 - 11, wherein the later process step comprises a metal deposition including a copper deposition.

13. The method of any of claims 1 - 11, wherein the later process step comprises a metal deposition including at least one of: a barrier deposition and a metal seed layer deposition.

14. The method of any of claim 1, wherein the prior step comprises an etch step; the later step comprises a metal deposition step; the cleaning step comprises performing a wet clean process using a solvent comprising dimethyl acetamide (DMAC); and the anneal step comprises performing an anneal to remove an absorbed component of the solvent after the wet clean process and prior to the metal deposition, the anneal being performed at a temperature higher than a boiling point of the component.

15. The method of claim 1, further comprising performing a plasma strip of the dielectric material to remove a photoresist residue after an etch of the material; wherein the cleaning step comprises performing a wet clean process using a fluorine-based solvent to remove a polymer residue of the plasma strip from the material; and wherein the anneal step comprises performing a low-pressure, high-temperature, limited-duration anneal after the wet clean process and prior to a metal barrier deposition to remove a component of the fluorine-based solvent from the dielectric material, whereby the anneal is exclusive of an application of a plasma generated from one or more of: a radio-frequency (RF) radiation and a microwave radiation.
